# EUROPÄISCHE PATENTSCHRIFT

(11) **EP 3 163 820 B1**
(45) Veröffentlichungstag und Bekanntmachung des Hinweises auf die Patenterteilung: **09.05.2018**
(21) Anmeldenummer: 15192363.8
(22) Anmeldetag: 30.10.2015
(51) Int. Cl.: H04L 25/02

(54) **BUSKOPPLER ZUM ANKOPPELN VON FELDGERÄTEN**
BUS COUPLER FOR COUPLING FIELD DEVICES
COUPLEUR DE BUS POUR DES APPAREILS DE TERRAIN

(43) Veröffentlichungstag der Anmeldung: 03.05.2017
(73) Patentinhaber: Siemens Aktiengesellschaft, 80333 München (DE)
(72) Erfinder: Volkmann, Hans, 90559 Burgthann (DE)

(56) Entgegenhaltungen:
- EP-A1- 2 383 622
- US-A- 5 835 534
- US-A1- 2001 022 714

## Beschreibung

Die Erfindung betrifft einen Buskoppler zum Ankoppeln von Feldgeräten an ein übergeordnetes Bussystem, umfassend einen Busanschluss für das übergeordnete Bussystem, jeweils einen Anschluss für jeweils ein Feldgerät, eine Haupt-Sende-Empfangseinheit ausgestaltet zum Senden und Empfangen von Telegrammen auf dem übergeordneten Bussystem, jeweils eine Sende-Empfangseinheit ausgestaltet zur Kommunikation mit je einem Feldgerät, wobei die jeweilige Sende-Empfangseinheit einen Signaleingang für Telegramme des übergeordneten Bussystems, welcher mit der Haupt-Sende-Empfangseinheit in Verbindung steht, einen Feldgerät-Ausgang für den Anschluss der Feldgeräte, über welche die Telegramme von der Haupt-Sende-Empfangseinheit an die Feldgeräte gesendet werden, einen Empfangssignalanschluss über welchen die Telegramme von den Feldgeräten an die Haupt-Sende-Empfangseinheit weitergeleitet werden, und einen Steuereingang aufweist.

Die US 5 835 534 A offenbart ein Feldbussystem und damit auch einen Feldbuskoppler, wobei dieser Feldbuskoppler die Eigenschaft eines intrinsichen Systems hat, wobei intrinsich in diesem Fall gekapselt bedeutet und insbesondere für den Einsatz in explosionsgefährdeten Umgebungen vorgesehen ist.

Erfindungsgemäß wird vorgeschlagen die jeweilige Sende-Empfangseinheit wie folgt auszugestalten, der Signaleingang steht mit einem ersten Eingang eines Impedanz-Wandlers in Verbindung, ein zweiter Eingang des Impedanz-Wandlers ist an ein steuerbares Referenzmittel angeschlossen, ein Ausgang des Impedanz-Wandlers ist mit einem Abschlusswiderstand in einer Reihenschaltung an den Feldgerät-Ausgang angeschlossen, wobei ein Messmittel zum Ermitteln eines Spannungsabfalls an dem Abschlusswiderstand angeschlossen ist und das Messmittel mit dem Referenzmittel in Verbindung steht. Mit Vorteil bildet der Abschlusswiderstand gleichzeitig einen Abschlusswiderstand mit einer Impedanz des Übertragungsmediums, also der Impedanz der Stückleitung zum Feldgerät, und einen Strombegrenzungswiderstand, wie er für Buskoppler bei einem Einsatz im Explosionsschutzbereichen gefordert ist.

Der Buskoppler weist eine Steuereinrichtung auf, welche ausgestaltet ist, über den Steuereingang das Referenzmittel hinsichtlich einer Referenzspannung für den zweiten Eingang anzupassen um einen Stromfluss durch den Abschlusswiderstand zu verringern und damit eine Strombegrenzung für den Feldgerät-Ausgang zu realisieren. Durch eine Kombination des Abschlusswiderstandes aus Abschlusswiderstand und Strombegrenzung kann mit Vorteil durch die Steuereinrichtung die Referenzspannung derart eingestellt, dass eine Strombegrenzung einstellbar ist oder auch eine gänzliche Abschaltung des Feldgerät-Ausgangs möglich ist. Ist das Feldgerät abgeschaltet, können sich Störeinkopplungen nicht mehr störend bemerkbar machen.

Auf einen zusätzlichen Strombegrenzungswiderstand für Geräte, welche in Ex-Schutzbereichen eingesetzt werden, kann nun mit Vorteil verzichtet werden.

In einer weiteren Ausgestaltung weist der Buskoppler zwischen dem Signaleingang und dem ersten Eingang des Impedanz-Wandlers ein Schaltmittel auf. Mit Vorteil kann der Signaleingang für Telegramme nun unterbrochen werden. Mit dem Schaltmittel kann ein Abschalten der Modulation der Haupt-Sende-Empfangseinheit erreicht werden, welches beispielsweise vorteilhaft für eine automatische Adressvergabe der Feldgeräte ist.

In einer besonders vorteilhaften Ausgestaltung ist der Impedanz-Wandler nach der Struktur eines Operationsverstärkers aufgebaut und derart ausgelegt, dass seine Ausgangs-Impedanz gegen Null geht und damit sein Ausgang einen virtuellen Massepunkt bildet, wodurch ein Empfangs-Telegramm, welches von dem zugehörigen Feldgerät gesendet wird, über den Empfangssignalanschluss an die Haupt-Sende-Empfangseinheit gelangen kann.

Im Hinblick auf eine erleichterte Diagnose ist an den Empfangssignalanschluss ein Diagnose-Signalaufbereitungsmittel zum Erfassen von Diagnosesignalen der Feldgeräte angeschlossen und ausgestaltet, die Diagnosesignale an die Steuereinrichtung weiterzuleiten.

Gemäß der Zeichnung werden Ausführungsbeispiele für den Buskoppler, insbesondere für die Ausgestaltung der Sende-Empfangseinheit dargestellt. Es zeigt
- FIG 1: einen Buskoppler mit mehreren Anschlüssen für Feldgeräte,
- FIG 2: eine Weiterentwicklung einer Sende-Empfangseinheit aus FIG 1,
- FIG 3: eine Ausgestaltung für eine Sende-Empfangseinheit bei Einsatz in einem FF-Verbund (Field Bus Foundation) und
- FIG 4: eine alternative Ausgestaltung eines Buskopplers bzw. einer Sende-Empfangseinheit, wobei die Funktion der Haupt-Sende-Empfangseinheit durch eine Kombination aus einer Stromanstiegsbegrenzungsschaltung und der entsprechend programmierten Steuereinrichtung realisiert ist.

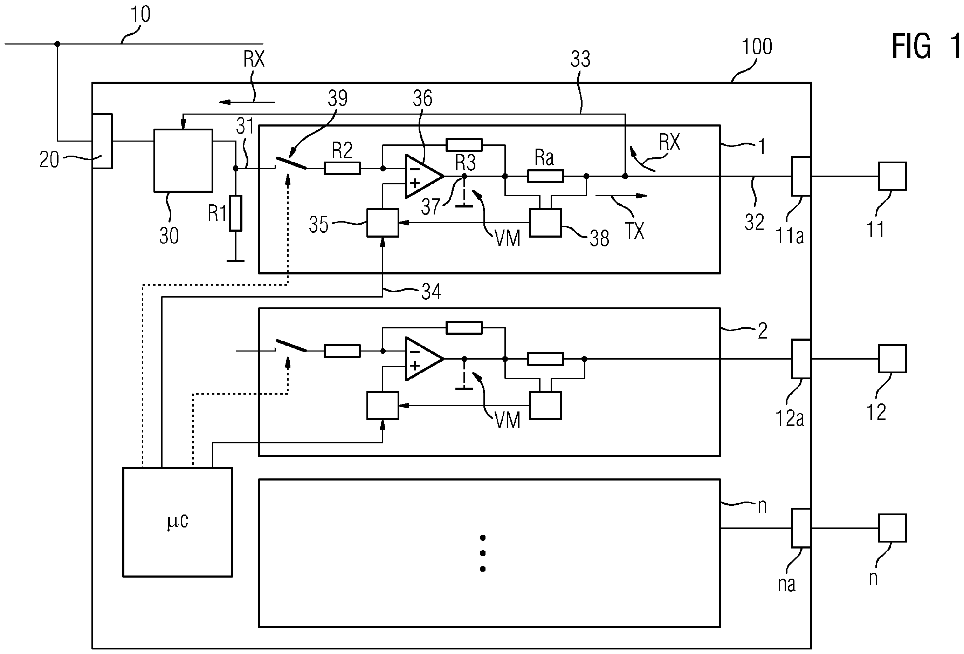

Gemäß FIG 1 ist ein Buskoppler 100 zum Ankoppeln von Feldgeräten 11,12,..,n an ein übergeordnetes Bussystem 10 dargestellt. Zum Anschluss des Buskopplers 100 an das übergeordnete Bussystem 10 weist der Buskoppler 100 einen Busanschluss 20 auf. Zum Ankoppeln der Feldgeräte 11,..,n an den Buskoppler 100 weist dieser einen ersten Anschluss 11a für das erste Feldgerät 11, einen zweiten Anschluss 12a für das zweite Feldgerät 12 und einen n-ten Anschluss na für das n-te Feldgerät n auf. Für jeweils einen Anschluss 11a,12a,..,na ist jeweils eine Sende-Empfangseinheit 1,2,..,n vorhanden. Da sich die Sende-Empfangseinheiten 1,...,n in ihrem Aufbau ähneln wird im folgenden nur die erste Sende-Empfangseinheit 1 detailliert beschrieben.

Die erste Sende-Empfangseinheit 1 weist einen Signaleingang 31 für Telegramme des übergeordneten Bussystems 10 auf, welcher mit der Haupt-Sende-Empfangseinheit 30 in Verbindung steht. Für eine Verbindung mit dem ersten Feldgerät 11 weist die erste Sende-Empfangseinheit 1 einen Feldgerät-Ausgang 32 für den Anschluss des ersten Feldgerätes 11 auf. Über diesen Feldgerät-Ausgang 32 können Telegramme TX, welche von der Haupt-Sende-Empfangseinheit 30 an die Feldgeräte 11,..,n gesendet werden, weitergeleitet werden.

Für Telegramme TX, welche von den Feldgeräten 11,..,n an die Haupt-Sende-Empfangseinheit 30 weitergeleitet werden, weist die erste Sende-Empfangseinheit 1 einen Empfangs-Signalanschluss 32 auf. Um über einen Steuereingang 34 steuernd auf die Sende-Empfangseinheit 1 einzugreifen, weist der Buskoppler 100 eine Steuereinrichtung µc auf. Die Steuereinrichtung µc kann über den Steuereingang 34 ein Referenzmittel 35 hinsichtlich einer Referenzspannung beeinflussen. Des Weiteren ist die Steuereinrichtung µc dazu ausgestaltet, auf ein Schaltmittel 39 Einfluss zu nehmen.

Der Signaleingang 31 der Sende-Empfangseinheit 1 steht mit einem ersten Eingang - eines Impedanz-Wandlers 36 in Verbindung, ein zweiter Eingang + des Impedanz-Wandlers 36 ist an das steuerbare Referenzmittel 35 angeschlossen. Ein Ausgang 37 des Impedanz-Wandlers 36 ist mit einem Abschlusswiderstand Ra in einer Reihenschaltung an den Feldgerät-Ausgang 32 angeschlossen. Zum Ermitteln eines Spannungsabfalls an dem Abschlusswiderstand Ra ist an diesem ein Messmittel 38 angeschlossen, wobei das Messmittel 38 mit dem Referenzmittel 35 in Verbindung steht. Da das Messmittel 38 stetig seine Messwerte an das Referenzmittel 35 weiterleitet, kann das Referenzmittel 35 durch eine entsprechende Spannungsvorgabe am zweiten Eingang + des Impedanz-Wandlers 36 den Ausgangsstrom am Ausgang 37 des Impedanz-Wandlers 36 einstellen oder sogar gänzlich abschalten.

Zwischen dem Signaleingang 31 und dem ersten Eingang - des Impedanz-Wandlers 36 ist das Schaltmittel 39 angeordnet. Mit dem Schaltmittel 39 können Telegramme von der Haupt-Sende-Empfangseinheit 30 gänzlich unterbrochen werden. Hiermit steht ein Schaltmittel zum Abschalten von Stichleitungen zur Vermeidung von Störeinkopplungen bei beispielsweise nicht angeschlossenen Feldgeräten zur Verfügung. Das Schaltmittel 39 kann auf vorteilhafte Weise die Modulation abschalten aber trotzdem könnte eine Versorgungsspannung für das Feldgerät aufrecht erhalten werden, welches z.B. für eine automatische Adressvergabe der Feldgeräte notwendig ist.

Der Impedanz-Wandler 36 ist nach der Struktur eines Operationsverstärkers aufgebaut und derart ausgelegt, dass seine Ausgangs-Impedanz gegen Null geht und damit bildet der Ausgang 37 einen virtuellen Massepunkt VM. Durch den virtuellen Massepunkt VM kann erreicht, dass Empfangs-Telegramme RX, welche von dem zugehörigen Feldgerät 11 gesendet werden, über den Empfangssignalanschluss 33 an die Haupt-Sende-Empfangseinheit 30 gelangen können. Der Impedanz-Wandler 36 erfährt durch einen dritten Widerstand R3 eine Gegenkopplung, ein zweiter Widerstand R2 dient als Eingangsstrombegrenzung für den ersten Eingang -. Ein erster Widerstand R1 ist gegen Masse an den Signaleingang 31 an der Haupt-Sende-Empfangseinheit 30 angeordnet.

Die Steuereinrichtung µc weist ein Programm auf, welches ausgestaltet ist, einen Spannungswert für das Referenzmittel 35 vorzugeben und weiterhin ausgestaltet ist, ein Abschalten von Modulationssignalen zur ersten Sende-Empfangseinheit 1 über das Schaltmittel 39 zu realisieren.

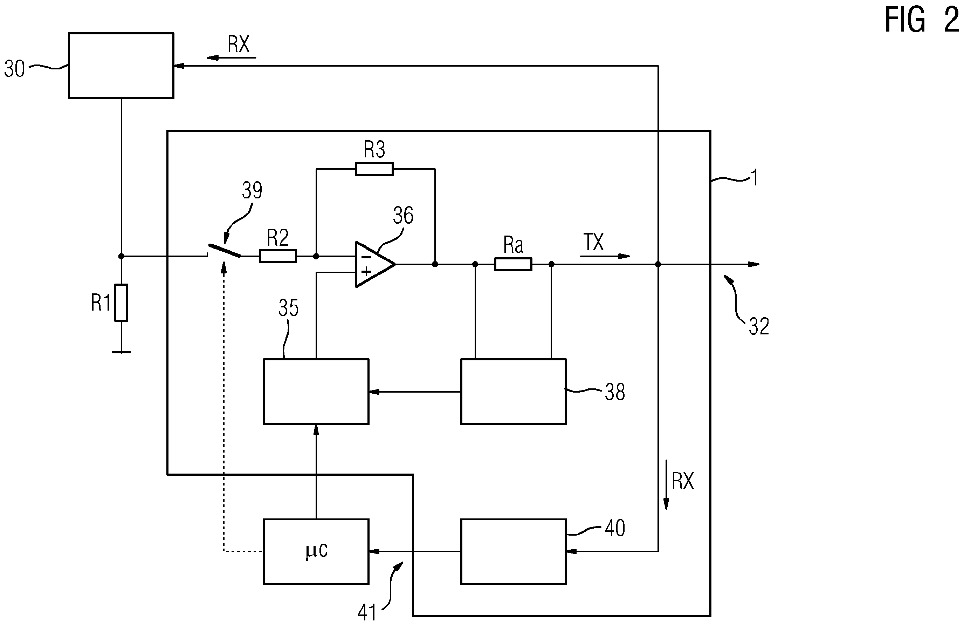

Mit der FIG 2 ist nicht mehr der ganze Buskoppler aus FIG 1 dargestellt, sondern nur noch eine Variante der Sende-Empfangseinheit 1 mit einer entsprechenden Steuereinrichtung µc und einer Haupt-Sende-Empfangseinheit 30. Gemäß FIG 2 ist zusätzlich zu der in FIG 1 offenbarten Sende-Empfangseinheit 1 nun an dem Empfangssignalanschluss 33 ein Diagnose-SignalAufbereitungsmittel 40 zum Erfassen von Diagnosesignalen der Feldgeräte 11,..,n angeschlossen. Das Diagnose-Signal-Aufbereitungsmittel 40 ist ausgestaltet die Diagnose-Signale an die Steuereinrichtung µc weiterzuleiten.

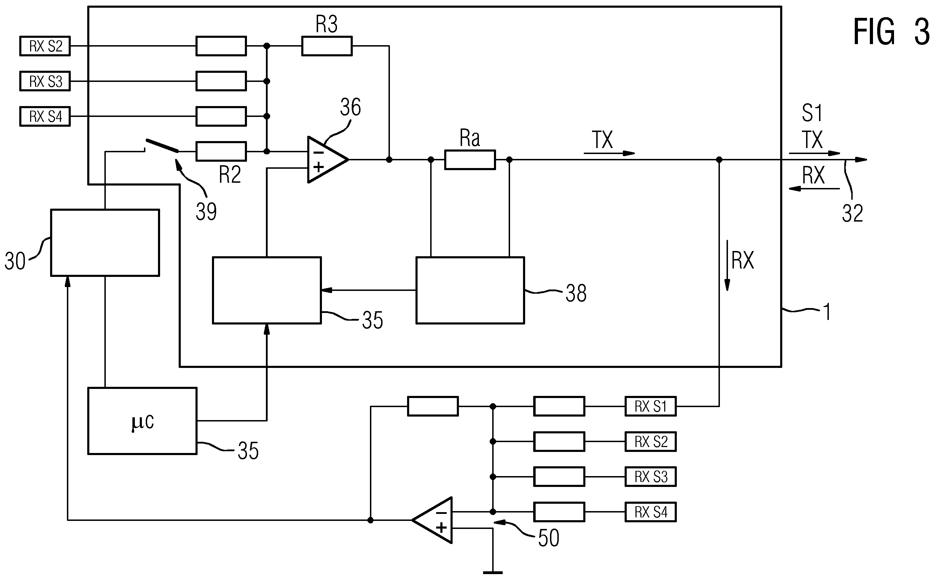

Mit der FIG 3 wird gezeigt, wie über den Impedanz-Wandler 36, ausgestaltet als ein Operationsverstärker, Bussignale bzw. Empfangstelegramme RX von anderen Feldgeräten, wie beispielsweise einen zweiten Feldgerät 12, einen dritten Feldgerät 13, und einen vierten Feldgerät 14 an das erste Feldgerät 11 übertragen werden können. Diese Übertragungsart ist beispielsweise bei Field Bus Foundation (FF) vorgesehen. Über einen Summierverstärker 50 werden die Empfangstelegramme oder Empfangssignale RX der übrigen Feldgeräte an die Haupt-Sende-Empfangseinheit 30 weitergeleitet.

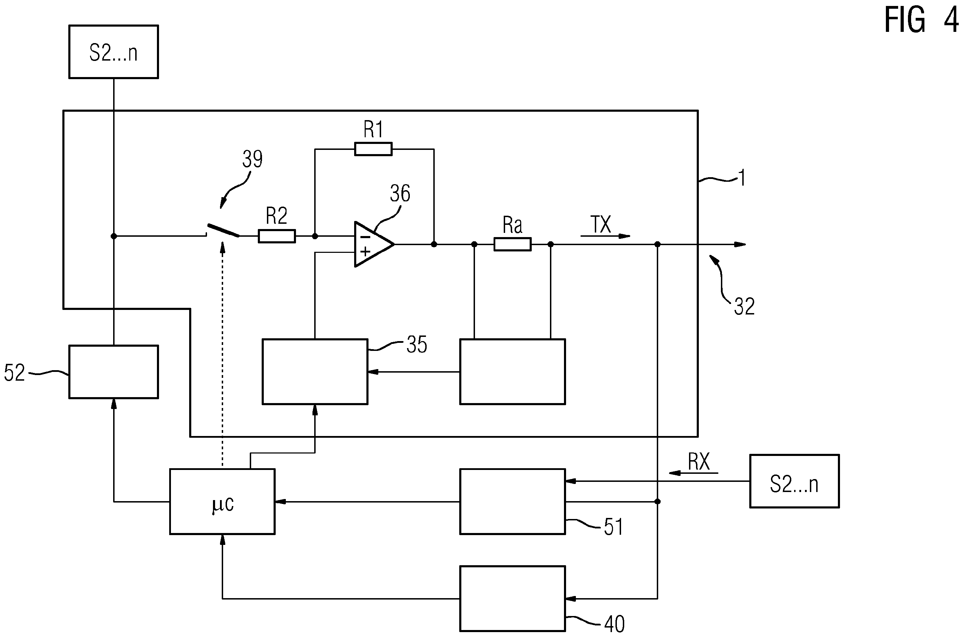

FIG 4 zeigt ein weiteres Beispiel, wobei die Haupt-Sende-Empfangseinheit 30 durch einen Empfängerbaustein 51 in Verbindung mit einer Strombegrenzungsschaltung 52 ersetzt wurde. Die Steuereinheit µc steuert dabei zusätzlich die Stromanstiegsbegrenzungsschaltung 52. An den Empfängerbaustein 51 können alle übrigen Feldgeräte mit ihren Empfangstelegrammen RX angekoppelt werden.

Weitere für die Erfindung wesentliche Gedanken sind folgende: Die Feldgeräte sind in der Regel in Ex-Zonen montiert, die im laufenden Betrieb nicht zugänglich sind, daraus ergibt sich eine Notwendigkeit, möglichst viele Diagnosedaten zu erfassen. Bei Profibus Automation (PA) oder Field Bus Foundation (FF) Bussystemen werden die Feldgeräte über Verteiler angeschlossen. Diese Verteiler können als der erfindungsgemäße Buskoppler betrachtet werden und beinhalten nach dem bisherigen Kenntnisstand der Erfinder für jede abgehende Spur S1,S2,S3,S4 zu den Feldgeräten jeweils eine Strombegrenzungsschaltung, Schaltungen für störungsfreies Anklemmen und Diagnoseeinrichtungen.

Eine Spur S1,S2,S3,S4 ist ein Stück Feldbusnetzwerk zwischen einem Verteiler bzw. einen Buskoppler und einem Feldgerät. Ein Modulationssignal wird dabei für alle Feldgeräte gemeinsam aufbereitet. Problematisch ist dabei, dass alle Feldgeräte verbunden sind und Störungen eines Gerätes auf die anderen Geräte übertragen werden können. Auch Diagnosemesswerte, wie z.B. Rauschen, Jitter und Signalpegel können nicht oder nur mit aufwändigen Schaltungen den einzelnen Geräten zugeordnet werden. Mit der Erfindung soll dem entgegen gewirkt werden, dass bisher Strombegrenzungen für jede Stichleitung bzw. jede Spur eingesetzt werden mussten.

Ein Abschlusswiderstand oder ein Busabschlusswiderstand für die Spurs S1,S2,S3,S4 ist mit typisch 50 Ohm nun in dem Verteiler bzw. in dem Buskoppler angeordnet und an dem Leitungsende zu dem Feldgerät ist das Feldgerät ohne einen Abschlusswiderstand angeschlossen.

An dem Abschlusswiderstand Ra in dem Buskoppler 100 wird die in dem System definierte Strommodulation zu einer Spannungsmodulation. Die vorteilhafte Anwendung eines Impedanz-Wandlers ausgestaltet als ein Operationsverstärker und eines Reihenwiderstand, nämlich der Abschlusswiderstand Ra, für jede Stichleitung ermöglicht, dass dieser Widerstand gleichzeitig ein Strombegrenzungswiderstand für Ex-Schutzbereiche und ein Abschlusswiderstand für die Leitung ist. Durch die Versorgung und die Modulation separat für jede Spur, sind in Verbindung mit dem steuerbaren Referenzmittel folgende Funktionen möglich: Eine Spannungsmodulation, ein Busabschlusswiderstnad für das Feldgerät, eine Strombegrenzung, ein Strombegrenzungswiderstand für Ex-Schutzbereiche, ein Summierverstärker für eine Kommunikationsverbindung zwischen den Feldgeräten an den verschiedenen Spurs S1,S2,S3,S4, wie es bei FF verwendet wird. Ein Schaltmittel zum Abschalten der Spurs S1,S2,S3,S4 zur Vermeidung von Störeinkopplungen bei nicht angeschlossenen Feldgeräten und Verringerung des Stromes bei fehlerhaften Leitungen durch Änderung der Referenzspannung. Bei einer Diagnose können die Bussignale zur Signalaufbereitung für jede Spur S1,S2,S3,S4 separat erfasst werden und der Steuereinrichtung µc zugeführt und ausgewertet werden.

## Patentansprüche

1. Buskoppler (100) zum Ankoppeln von Feldgeräten (11,..,n) an ein übergeordnetes Bussystem (10), umfassend
- einen Anschluss (20) für das übergeordnete Bussystem (10),
- jeweils einen Anschluss (11a,12a,..,na) für jeweils ein Feldgerät (11,..,n),
- eine Haupt-Sende-Empfangseinheit (30) ausgestaltet zum Senden und Empfangen von Telegrammen auf dem übergeordneten Bussystem (10),
- jeweils eine Sende-Empfangseinheit (1,..,n) ausgestaltet zur Kommunikation mit je einem Feldgerät (11,..,n),
wobei die jeweilige Sende-Empfangseinheit (1,..,n)
- einen Signaleingang (31) für Telegramme des übergeordneten Bussystems (10), welcher mit der Haupt-Sende-Empfangseinheit (30) in Verbindung steht,
- einen Feldgerät-Ausgang (32) für den Anschluss der Feldgeräte (11,..,n), über welchen die Telegramme von der Haupt-Sende-Empfangseinheit (30) an die Feldgeräte (11,..,n) gesendet werden,
- einen Empfangssignalanschluss (33), über welchen die Telegramme von den Feldgeräten (11,..,n) an die Haupt-Sende-Empfangseinheit (30) weitergeleitet werden, und
- einen Steuereingang (34) aufweist, und **dadurch gekennzeichnet ist, dass** sie wie folgt ausgestaltet ist
der Signaleingang (31) steht mit einem ersten Eingang (-) eines Impedanz-Wandlers (36) in Verbindung, ein zweiter Eingang (+) des Impedanz-Wandlers (36) ist an ein steuerbares Referenzmittel (35) angeschlossen,
ein Ausgang (37) des Impedanz-Wandlers (36) ist mit einem Abschlusswiderstand (Ra) in einer Reihenschaltung an den Feldgerät-Ausgang (32) angeschlossen,
wobei ein Messmittel (38) zum Ermitteln eines Spannungsabfalls an dem Abschlusswiderstand (Ra) angeschlossen ist und das Messmittel (38) mit dem Referenzmittel (35) in Verbindung steht,
wobei der Impedanz-Wandler (36) nach der Struktur eines Operationsverstärkers aufgebaut ist,
des Weiteren aufweisend,
- eine Steuereinrichtung (µC), welche ausgestaltet ist über den Steuereingang (34) das Referenzmittel (35) hinsichtlich einer Referenzspannung für den zweiten Eingang (+) anzupassen um einen Stromfluss durch den Abschlusswiderstand (Ra) zu verringern und damit eine Strombegrenzung für den Feldgerät-Ausgang (32) zu realisieren.

2. Buskoppler (100) nach Anspruch 1, wobei zwischen dem Signaleingang (31) und dem ersten Eingang (-) des Impedanz-Wandlers (36) ein Schaltmittel (39) angeordnet ist.

3. Buskoppler (100) nach einem der Ansprüche 1 oder 2, wobei der Impedanz-Wandler (36) derart ausgelegt ist, dass seine Ausgangsimpedanz gegen Null geht und damit einen virtuellen Massepunkt (VM) bildet, wobei dadurch ein Empfangs-Telegramm (RX), welches von dem zugehörigen Feldgerät (11,..,n) gesendet wird, über den Empfangssignalanschluss (33) an die Haupt-Sende-Empfangseinheit (30) gelangt.

4. Buskoppler (100) nach einem der Ansprüche 1 bis 3, wobei an dem Empfangssignalanschluss (33) ein Diagnose-Signal-Aufbereitungsmittel (40) zum Erfassen von Diagnosesignalen der Feldgeräte (11,..,n) angeschlossen ist und ausgestaltet ist, die Diagnosesignale an die Steuereinrichtung (µC) weiterzuleiten.

## Claims

1. Bus coupler (100) for coupling field devices (11,..,n) to a superordinate bus system (10), comprising
- a connection (20) for the superordinate bus system (10),
- in each case a connection (11a,12,..,na) for, in each case, one field device (11,..,n),
- a main transmit-receive unit (30) configured to transmit and receive telegrams on the superordinate bus system (10),
- in each case a transmit-receive unit (1,..,n), configured to communicate with each field device (11,..n),
wherein the respective transmit-receive unit (1,...n)
- has a signal input (31) for telegrams of the superordinate bus system (10), which is connected to the main transmit-receive unit (30),
- a field device output (32) for the connection of the field devices (11,..,n), by way of which the telegrams are sent from the main transmit-receive unit (30) to the field devices (11,..n),
- a receive signal connection (33), by way of which the telegrams are forwarded from the field devices (11,..,n) to the main transmit-receive unit (30), and
- a control input (34)
and **characterised in that** it is configured as follows
the signal input (31) is connected to a first input (-) of an impedance converter (36), a second input (+) of the impedance converter (36) is connected to the controllable reference means (35),
an output (37) of the impedance converter (36) is connected to a terminating resistor (Ra) in a series circuit at the field device output (32),
wherein a measuring means (38) for determining a voltage drop is connected to the terminating resistor (Ra) and the measuring means (38) is connected to the reference means (35),
wherein the impedance converter (36) is designed according to the structure of an operational amplifier,
further having,
- a control facility (µC), which is configured to adjust the reference means (35) in respect of a reference voltage for the second input (+) by way of the control input (34) in order to reduce a current flow through the terminating resistor (Ra) and thus to realise a current limitation for the field device output (32).

2. Bus coupler (100) according to claim 1, wherein a switching means (39) is arranged between the signal input (31) and the first input (-) of the impedance converter (36).

3. Bus coupler (100) according to one of claims 1 or 2, wherein the impedance converter (36) is configured such that its output impedance approaches zero and thus forms a virtual ground point (VM), wherein as a result a receive telegram (RX) which is sent by the associated field device (11,..n) reaches the main transmit-receive unit (30) by way of the receive signal connection (33).

4. Bus coupler (100) according to one of claims 1 to 3, wherein a diagnosis signal preparation means (40) to detect diagnosis signals of the field devices (11.,,n) is connected to the receive signal connection (33) and is configured to forward diagnosis signals to the control facility (µC).

## Revendications

1. Coupleur (100) de bus pour coupler des appareils (11, .., n) sur site à un système (10) de bus supérieur hiérarchiquement, comprenant
- un accès (20) pour le système (10) de bus supérieur hiérarchiquement,
- respectivement un accès (11a, 12a, .., na) pour respectivement un appareil (11, .., n) sur site,
- une unité (30) principale d'émission-réception, conformée pour envoyer et recevoir des télégrammes sur le système (10) de bus supérieur hiérarchiquement,
- respectivement une unité (1, .., n) d'émission-réception, conformée pour communiquer avec respectivement un appareil (11, .., n) sur site,
dans lequel l'unité (1, .., n) respective d'émission-réception a
- une entrée (31) de signal pour des télégrammes du système (10) de bus supérieur hiérarchiquement, qui est en liaison avec l'unité (30) principale d'émission-réception,
- une sortie (32) d'appareil sur site pour le raccordement des appareils (11, .., n) sur site, par laquelle les télégrammes sont envoyés de l'unité (30) principale d'émission-réception aux appareils (11, .., n) sur site,
- un accès (33) de signal de réception, par lequel les télégrammes sont acheminés des appareils (11, .., n) à l'unité (30) principale d'émission-réception et
- une entrée (34) de commande,
et **caractérisé par** la constitution suivante
l'entrée (31) de signal est en liaison avec une première entrée (-) d'un convertisseur (36) d'impédance, une deuxième entrée (+) du convertisseur (36) d'impédance est raccordée à un moyen (35) de référence pouvant être commandé,
une sortie (37) du convertisseur (36) d'impédance est raccordée par une résistance (Ra) terminale d'un circuit série à la sortie (32) d'appareil sur site,
dans lequel un moyen (38) de mesure pour déterminer une chute de tension est raccordé à la résistance (Ra) terminale et le moyen (38) de mesure est en liaison avec le moyen (35) de référence,
dans lequel le convertisseur (36) d'impédance est conformé suivant la structure d'un amplificateur opérationnel, comportant en outre
- un dispositif (µC) de commande, conformé pour adapter, par l'entrée (34) de commande, le moyen (35) de référence en ce qui concerne une tension de référence pour la deuxième entrée (+) afin de diminuer le flux du courant passant dans la résistance (Ra) terminale et réaliser ainsi une limitation du courant pour la sortie (32) de l'appareil sur site.

2. Coupleur (100) de bus suivant la revendication 1, dans lequel un moyen (39) de commutation est monté entre l'entrée (31) du signal et la première entrée (-) du convertisseur (36) d'impédance.

3. Coupleur (100) de bus suivant l'une des revendications 1 ou 2, dans lequel le convertisseur (36) d'impédance est conçu de manière à ce que son impédance initiale passe par zéro et forme ainsi un point (VM) à la masse virtuel, en sorte qu'un télégramme (RX) de réception, qui est envoyé par l'appareil (11, .., n) sur site associé, arrive par l'accès (33) pour un signal de réception à l'unité (30) principale d'émission-réception.

4. Coupleur (100) de bus suivant l'une des revendications 1 à 3, dans lequel un moyen (40) de traitement de signal de diagnostic, pour détecter des signaux de diagnostic des appareils (11, .., n) sur site, est raccordé à l'accès (33) de signal de réception et est conformé pour acheminer les signaux de diagnostic au dispositif (µC) de commande.
